Europäisches Patentamt

**European Patent Office**

Office européen des brevets

(19)

(11) Publication number: **0 067 384**
**A2**

(12) **EUROPEAN PATENT APPLICATION**

(21) Application number: **82104928.5**

(22) Date of filing: **04.06.82**

(51) Int. Cl.³: **G 06 F 5/00**

(30) Priority: **17.06.81 US 274420**

(43) Date of publication of application:
**22.12.82 Bulletin 82/51**

(84) Designated Contracting States:
**DE FR GB**

(71) Applicant: DIGITAL EQUIPMENT CORPORATION
146 Main Street
Maynard, MA 01754(US)

(72) Inventor: Weng, Lih-Jyh
6 Bicentenniel Drive
Lexington Massachusetts(US)

(72) Inventor: Field, Norman A.
4 Charles Street
Maynard Massachusetts(US)

(74) Representative: Baillie, Iain Cameron et al,
c/o Ladas & Parry Isartorplatz 5
D-8000 München 2(DE)

(54) **Circuit for serializing and deserializing digital data.**

(57) A circuit for serializing and deserializing digital data comprising at least two identical shift register circuits having common serial input ports and common parallel input and output ports. In a serial-to-parallel mode, one shift register alternately operates to receive serial data while the other shift register alternately operates to transmit a parallel word. In a parallel-to-serial mode of operation, one shift register alternately operates to receive a parallel word while the other shift register alternately operates to transmit serial data. The circuit further includes a automatic self-starting, word framing auto-correlating detector circuit for automatically starting and framing parallel words transfers upon detection of a unique "sync" pattern during the serial-to-parallel mode of operation. The detector circuit permits detection of the sync pattern even though some of the bits thereof are in error.

EP 0 067 384 A2

Croydon Printing Company Ltd.

## Background of the Invention

This invention relates to circuits for serializing and deserializing digital data during transfer thereof between devices of a data processing system.

In a digital data processing system, a device such as a processor performs operations on a "word". The "word" comprises a predetermined fixed number of data "bits". When the operation is completed, the word is usually transferred to another device, such as a memory unit or storage unit. We characterize the processor, and other devices that perform operation on words, as parallel devices because they usually transfer "bits" of the word in parallel. Another device in the data processing system, such as a disk storage unit, might only possess the capability to handle data sequentially transferred therewith on a bit-by-bit basis. We characterize this device as a serial device. When parallel and serial devices intercommunicate, words must be converted to a serial data bits and/or serial data bits must be converted to words. A serializer/deserializer circuit performs these conversion operations.

Conventional serializer/deserializer circuits comprise a shift register and a buffer. The shift register comprises a plurality of successively connected stages each being adapted to receive a data bit from a preceding stage thereof at predetermined clock intervals. The first stage, however, receives its data bits from the serial device and the last stage transmits its data bits to the serial device.

- 1 -

> The references to the drawings
> Fig 7A + 7B
> are deemed to be deleted (R. 43 EPC)

The buffer also comprises a plurality of stages. Each stage of the buffer connects to a corresponding stage of the shift register. When so connected, data bits can be transferred between the respectively connected stages of the shift register and the buffer. The buffer also connects to the parallel device so that it may transmit and receives words therewith.

In the serial-to-parallel mode of operation, the shift register receives at its first stage serial data transmitted by the serial device, and when a predetermined number of data bits equal to the bit-length of the word to be transferred has been shifted into the stages thereof, all data bits then present in the shift register are transferred in unison to the buffer. In order to maintain continuity in the serial data flow, this parallel transfer must rapidly take place with each stage of the shift register within a single "bit" time. The bit time is defined by the clocking interval; that is, the time between shifting of data bits into the first stage of the shift register. Such rapid transfers require a greater amount of electrical power than slower bit rate transfers. Greater word length necessitates even greater power requirements as each stage of the shift register requires a "fast" switching gate. After all bits of the word have been transferred to the buffer, the word is then transferred to the parallel device. Meanwhile, the shift register continues to serially receive data bits. If the shift register becomes full before the serial data can be

- 2 -

transferred to the parallel device (e.g. "word" time), an overrun condition results thereby interrupting the continuity of the serial data transfer. In a serial data storage device, such as a disk drive, overruns that occur before completion of a block transfer necessitate a subsequent reading attempt in order to correctly retrieve the data because the rotating disk cannot be halted while the sector is being read.

In the parallel-to-serial mode of operation, a parallel word is first transferred to the buffer and thereafter, it is transferred in parallel to the shift register. The shift register then serially shifts, or transmits, data bits to the serial device while the buffer receives another parallel word. When the shift register has serially shifted all of its bits of the word to the serial device, it again receives, in unison and in parallel, the set of data bits then present in the buffer. Again, to maintain continuity in the serial data flow, this transfer must also rapidly take place prior to the time for transmitting the next serial bit to the serial device. This process is repeated by the shift register and buffer until the transfer is completed.

From the foregoing, it is evident that substantial power is consumed by conventional shift register/buffer circuits both in the serial-to-parallel and parallel-to-serial modes of operation in order to maintain continuity in the serial data flow. During circuit operation, the consumed power is converted to heat energy which is dissipated through the circuit elements. Only a certain amount of heat energy can be tolerated without damaging these circuit elements. Power consumption, and therefore heat energy, can be reduced if the transfer rate between the shift register and the buffer is decreased. Such a decrease would enable the switching logic in the register and buffer circuits to operate at lower power levels. This solution, though, has the obvious disadvantage of retarding the transfer rate, or data throughput. In some cases, such as for LSI circuits, power consumption must be held below a certain level due to the operating environment of the circuit. Thus, data throughput is limited by any given power limitation imposed upon the serializer/deserializer circuit.

Conventional serializer/deserializer circuits suffer yet other difficulties. Specifically, improper framing of the serial bit stream to form parallel words may occur during serial-to-parallel mode of operation, in which case, all parallel words that are subsequently transferred from the shift register to the buffer, and ultimately to the parallel device, would be erroneous. This problem is most likely to come about during the initial input of serial data to the shift register.

Previous methods for framing words, or demarcating the serial bit stream, include placing a "sync" bit (logical "one") in the serial data stream preceded by a search field comprising a number of "zeroes". A detector monitors the passage of the search field and starts a periodic word rate clock upon detection of the "sync" bit. A serial data field following the "sync" bit is then segmented and transferred in proper lengths at fixed time intervals according to a word rate clock that is started upon detection of the "sync" bit. The word rate clock synchronizes the transfer of a predetermined number of serial bit transfers in the shift register with a single parallel word transfer in the buffer. Rather than employing a "sync" bit, a more recent approach has been to employ a "sync" byte, for more reliable starting of the word rate clock. Neither of these systems, however, will tolerate erroneous data in the search field that resembles the "sync" pattern, nor will it tolerate errors occurring in the "sync" pattern itself. The circuit is subject to early starts if the search field contains the sought after "sync" pattern, or it is subject to late starts if the actual "sync" pattern becomes altered and a similar pattern is detected in the data field. Redundancy in the sync pattern could be employed to reduce, in limited error conditions, the possibilities of early and late starts. The this solution would, however, reduce data rate of the system.

Yet another system, such as described in U.S. Patent 3,668,632 issued to Oldham, III, uses the starting pattern $Y^nX...Y^3XY^2XY^1X$ where Y = zero and X = one (i.e. 00001000100101) that is preceded by a series of "ones". The fourteen-bit starting pattern constructed according to the Oldham patent has a minimum Hamming distance of seven and therefore, up to three bits in error can be tolerated therein.

In view of the foregoing, an objective of this invention is to provide a circuit for improving data transfer operations between parallel and serial devices of a digital data processing system.

Another objective of this invention is to provide a serializer and deserializer circuit of relatively low power consumption and a high data transfer rate.

Another objective of this invention is to provide a serializer/deserilizer circuit that can simply and economically be constructed from a plurality of substantially identical circuit elements and thus save circuit design and layout costs.

A further objective of this invention is to provide a unique serial bit pattern and a detector circuit therefore for reducing the likelihood of premature and late detection of "sync" pattern thereby to provide more reliable demarcation of the serial data bits into word segments of proper length.

## Summary

In accordance with this invention, a serializer/deserializer circuit useful for transferring data between parallel and serial data handling devices of a data processing system comprises at least two shift register circuits including common serial input and serial output

- 6 -

ports respectively coupling the input and output stages of each shift register, and a common parallel input/output port that couples the stages of each shift register. The circuit also comprises a controller which, during the serial-to-parallel mode, successively enables each shift register to receive serial input data while another shift register transmits a parallel word; and during the parallel-to-serial mode, successively enables each shift register to receive a parallel word while another shift register transmits serial data. This circuit allows at least an entire "word" time, rather than a single "bit" time, to perform a parallel bit transfer of a word to a parallel device from an enabled one of the shift registers.

The common serial input and output ports enable several of the serializer/deserializer circuits to be cascaded so that they may operate in a serial-to-serial mode, as between themselves, while a copy of a parallel word is transferred from each of the circuits. Cascading is useful when different parallel devices are to perform different operations on the same parallel word.

Another aspect of the invention comprises, for use in the serial-to-parallel mode of operation, a self-starting, word-framing "sync" pattern detector circuit that reliably detects the presence of a unique n-bit sequence of bits in the serial bit stream for automatically starting and framing parallel word transfers, even in a high error rate environment. The n-bit sequence of bits, or "sync" pattern, follows a search field (which could be all "zeroes") with which the "sync" pattern possesses auto-correlation properties. The "sync" pattern is that which yields the maximum Hamming distance for a given pattern length so as to maximize the error tolerance of a threshold detector circuit that monitors the number of bits in disagreement in the serial data bits during transmission thereof to the shift register.

Another aspect of the invention comprises circuitry in the controller for enabling the shift register circuitry to serialize and deserialize words of different word lengths.

This invention is pointed out with particularity in the appended claims. The above and further objects and advantages of this invention may be attained by reference to the following detailed description taken in conjunction with the accompanying drawings.


Brief Description of the Drawings

Fig. 1 depicts a serializer/deserializer circuit embodying this invention.

Fig. 2A shows data bits of a preamble and sync pattern together with one shift register and sync pattern detector circuit depicted in Fig. 1.

Fig. 2B illustrates the auto-correlation property of the sync pattern shown in Fig. 2A.

Figs. 2C through 2E are tables from which suitable sync patterns can be selected according to their pattern length and Hamming distance.

Figs. 3A and 3B show timing diagrams depicting the serial-to-parallel mode of operation of the serializer/deserializer circuit.

Figs. 4A and 4B show timing diagrams depicting the parallel-to-serial mode of operation of the serializer/deserializer circuit.

Fig. 5 shows a timing diagram depicting the serial-in/parallel-and-serial-out mode of operation when several of the circuits are cascaded.

Figs. 6A and 6B depict the circuitry of the shift registers of Fig. 1.

Figs. 7A and 7B depict the control portion of the circuit of Fig. 1.

## Description of an Illustrative Embodiment

### General Description

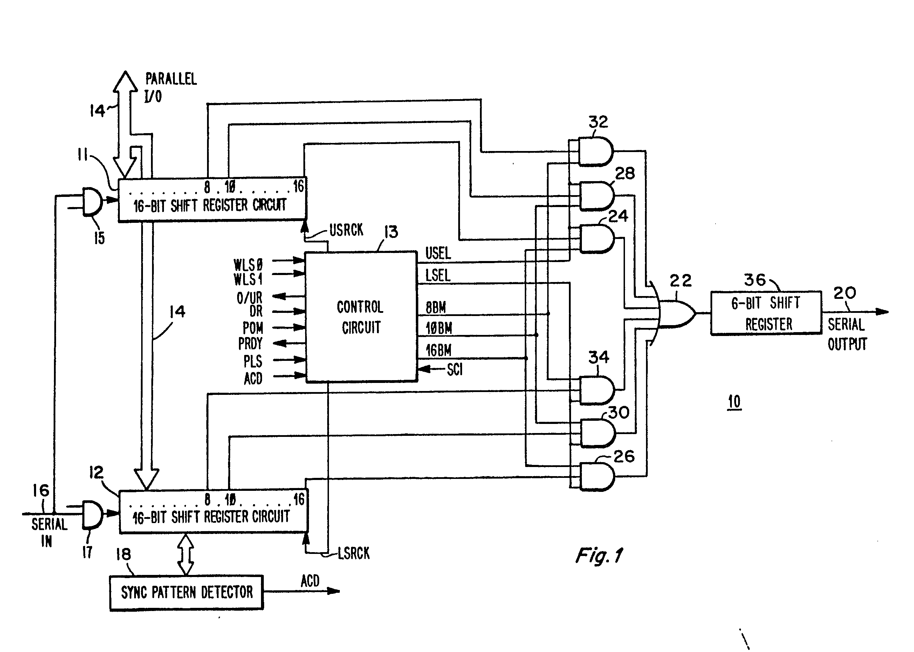

Fig. 1 shows a circuit that embodies our invention. It includes two 16-bit shift registers 11 and 12 which operate to convert serial data to parallel words, or parallel words to serial data. It will become apparent that three or more shift registers also can be used to accomplish the objectives of this invention. A control circuit 13 switches, back and forth, the registers 11 and 12 so that, in a first conversion cycle, the upper register 11 performs a parallel word transfer operation with a parallel device (not shown) while the lower register 12 performs a serial data transfer operation with a serial device (not shown); and during the next conversion cycle, the lower register 12 performs the parallel word transfer operation with the parallel device while the upper register 11 performs the serial data transfer operation with the serial device. This process is repeated, in an alternating fashion, during the operation of the circuit 10.

Transfers of serial data bits from the serial device usually occur at a much faster rate than transfers of words from a parallel device. As previously stated, most prior art serializer/deserializer circuits comprise a shift register and a buffer connected in parallel. During both their parallel-to-serial and serial-to-parallel modes of operation, the data bits are simultaneously transferred within a single "bit" time between the shift register stages and the buffer stages. Substantial power is consumed during this simultaneous transfer. In our circuit, however, only AND gates 15 and 17 or 24-34 are required to be rapidly switched within a single "bit" time to transmit or receive serial data while parallel word transfer may take place during an entire "word" time. The additional time period allows the control circuit 13 to perform a handshake operation with the parallel device for indicating the completion of a parallel word transfer, in or out. The shift register 11 or 12 can thus prepare to transfer another parallel word within the allotted "word" time.

To transfer a parallel word in the serial-in/parallel-out mode, the control circuit 13 synchronously generates a PRDY signal when a parallel word has been assembled in one of the registers 11 or 12 thereby to indicate that a parallel word can be taken by the parallel device from the circuit via the parallel I/O port 14. While a word is being taken from one shift register, serial data can be accepted, without interruption, by the other shift register thereby to attain a relatively fast serial bit rate despite a relatively slower parallel word rate. To accomplish the handshake, the parallel device takes the word, responds to the control circuit 13 with a DR signal, and then the circuit 13 negates a PRDY signal until the next parallel word is ready. This operation is subsequently described in greater detail.

In the parallel-in/serial-out mode, the control circuit 13 again generates a PRDY when it is ready to receive a parallel word, and responds to an externally applied PLS signal by loading a parallel word then present on the parallel I/O port 14 into one of the registers 11 or 12. When a word has been loaded into a selected shift register, the control circuit 13 conditions it to serially transmit the bits of the word from the eight, tenth, or sixteenth stage of the shift register and simultaneously conditions the other shift register to receive another word in parallel to

- 11 -

complete the handshake, in this case, the control circuit then negates PRDY until the circuit is ready to receive the next parallel transfer.

## Sync Pattern Detector

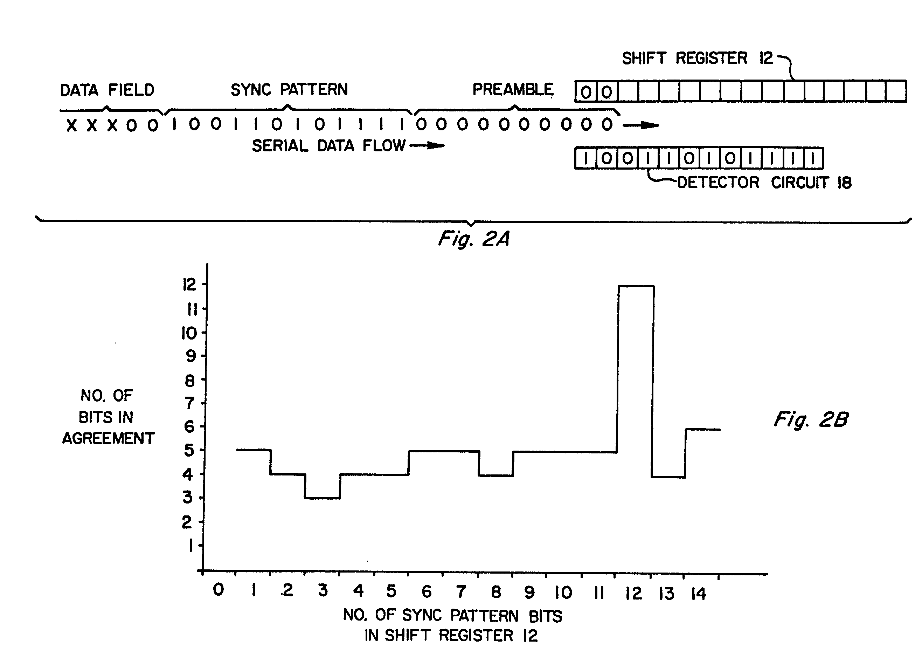

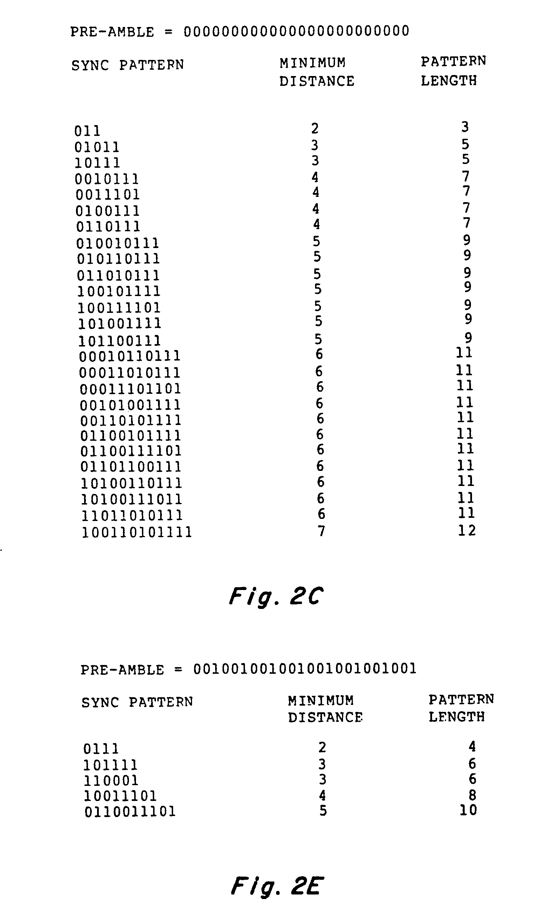

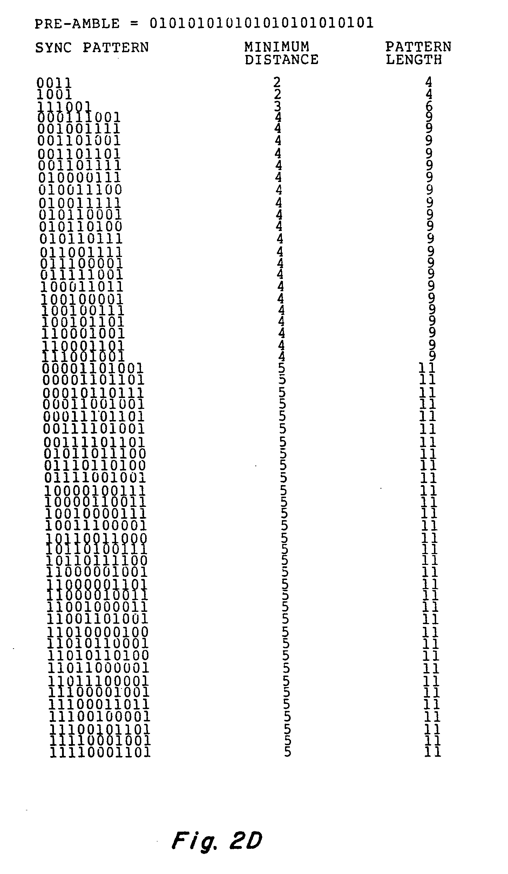

We found that a bit sequence having certain desirable auto-correlation properties would be most suitable for starting parallel word transfers in a serial-in parallel-out mode because it would be less susceptable to false, early, or late starts when transferring data with high error rates. The preferred auto-correlating "sync" pattern is depicted in Fig. 2A as "100110101111" (the rightmost bit being first shifted into the detector). This pattern is selected from the last entry in the table of Fig. 2C. Of course, should the preamble be all "ones", then complement of the preferred "sync" would be used. Referring to Fig. 2B, it is seen that as the preferred "sync" pattern preceded by a preamble of any number of "zeroes" is being shifted, bit-by-bit, into the shift register 12, no more than five-out-of-twelve bits will be in agreement with the sync pattern bits stored in detector circuit 18 until all twelve are shifted into the shift register.

The tables of Figs. 2C through 2E were produced, for all patterns of a given length and the indicated preamble, by determining their auto-correlation property (i.e. number of bits in agreement during shifting) as illustrated in Fig. 2B. For a given pattern length, we selected the particular pattern having the greatest minimum distance as it provided a detector circuit having the highest error tolerance. For our invention, we found that the sync pattern "100110101111" being twelve bits long provided a minimum distance of seven. A detector circuit using this pattern length could also be constucted with fewer circuit components than sync patterns having longer lengths, and thus we were able to meet our economic objectives.

To detect a "sync" pattern which has been corrupted due to some of its bits being altered, we provide a threshold detector circuit in the circuit 18 comprising twelve current sources, each of which being de-energized by a "true" comparison between respective bits of twelve positions in the first twelve stages of shift register 12 and corresponding bits of the twelve positions of the detector circuit 18. The sum of these current sources produces a larger current whose magnitude corresponds to the number of bits in disagreement. When the appropriate twelve bits of the "sync" pattern are present therein, the threshold level detector circuit produces a current source of level "zero". When all bits are in disagreement, the threshold detector circuit produces a current source of twelve units. As previously indicated, the auto-correlation properties of the "sync" pattern together with an all "zero" preamble yield no more than five bits in agreement, (i.e. seven or more bits in disagreement) while being shifted into the register 12. Accordingly, the detector circuit 18 generates, at least, a current source of seven units until all matching twelve bits are present in shift register 12. So, during shifting, if the detector circuit 18 "sees" more than five bits in agreement (less than seven bits in disagreement), then there is a likelihood that it has detected the "sync" pattern. To be certain of this condition, the threshold detector circuit is set to respond to current levels of less than 3.5 units. It responds by triggering the circuit 18 to generate the ACD signal thereby indicating the detection of the sync pattern. So, even if up to three bits of the sync pattern are in error when all twelve bits thereof are present in the shift register, the threshold circuit will "see" at least nine bits in agreement, and a current level of three or less units representing three or less bits in disagreement will trigger the detector circuit 18.

## Serial-In/Parallel-Out Mode

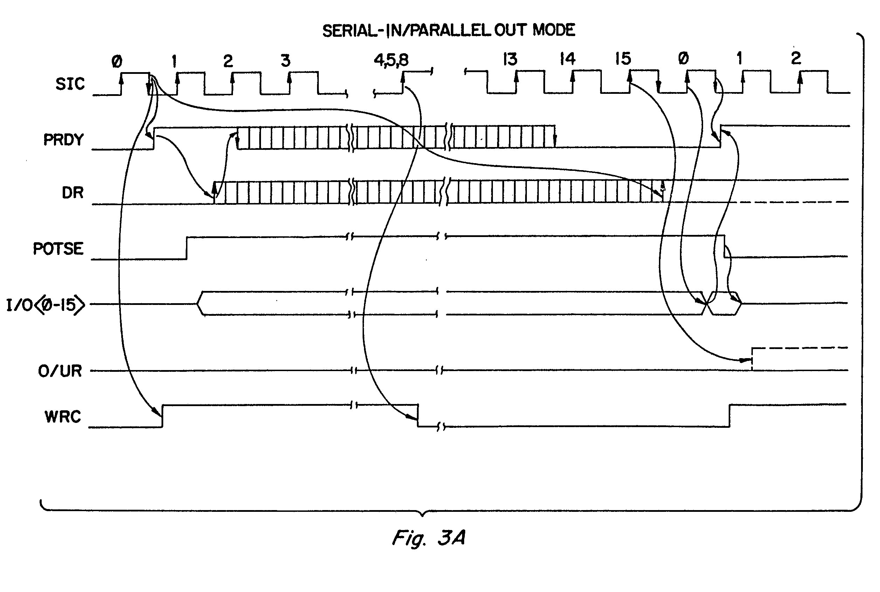

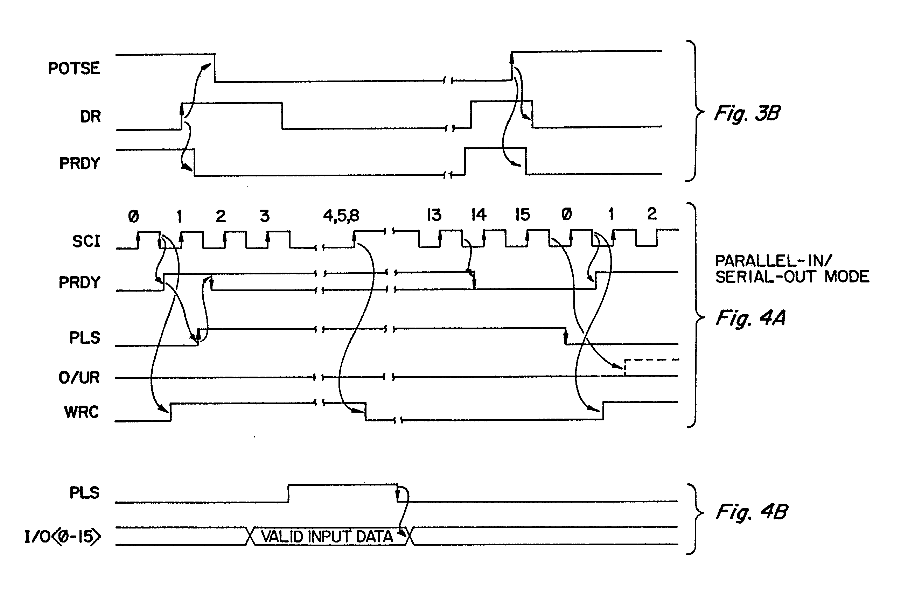

Refer to Fig. 1 and the timing diagrams of Figs. 3A and 3B. When a POM signal is asserted, the circuit 10 operates in the serial-to-parallel mode. In this mode, the registers are cleared and the data bits are shifted into the shift registers 11 and 12 upon each assertion of an SCI serial input clocking pulse. Thereafter, parallel word transfers are started by an ACD signal generated by the sync byte detector circuit 18. The ACD signal is asserted when the circuit 18 detects the presence of the sync pattern in
the shift register 12, as previously explained. A comparator
might constitute the circuit 18.  Thereafter, word transfers
are periodically repeated between subsequent m-bit word
frames.

Parallel word transfers with the registers 11 and
12 can occur, in our preferred embodiment, in 8-bit, 10-bit,
or 16-bit word frames, depending upon the status of WSL0 and
WSL1 control signals which set the circuit 13 in selective
control states to effect switching between the registers 11
and 12 at 8-bit, 10-bit, or 16-bit intervals.  The invention,
however, can be modified, according to the teachings herein,
to transfer parallel words of any bit length.  In any event,
parallel words are transmitted by or received from an
appropriate number of conductors of the parallel I/O port 14.

Assuming the sync pattern has been detected by the
detector circuit 18, the control circuit 13 temporarily
inhibits one of the shift registers, say register 12, from
receiving serial data bits, starts a WRC word rate clocking
signal, and enables itself to transmit PRDY and receive a DR
signal.  The parallel words are not transmitted until the
PRDY signal becomes asserted.  It is asserted precisely one
word "time" after detection and passage of the "sync"
pattern.  To the parallel device, the PRDY signal indicates
that the data bits in the register 12 are ready to be
transmitted, as a word, over the parallel I/O port 14.  In
order to take the data bits present from the shift register

- 15 -

12, the device asserts a POTSE signal which enables tri-state drivers connected to the outputs of the stages of shift register 12. When the word has been received, the parallel device sends a DR signal to the control circuit 13 thereby indicating that the parallel word has been received. The control circuit 13 negates its PRDY signal in response to the DR signal. This can occur within eight, ten, or sixteen SCI cycles. The parallel device acknowledges receipt of the word by asserting a DR signal which causes negation of the PRDY signal. This negation prepares the circuit 10 for a similar operation with respect to the other register 11. If the DR signal is not asserted within the time period determined by the WLS0 and WSL1 control bits, the circuit 13 asserts an O/UR signal thereby signalling an overrun/underrun condition.

After a number of SCI clock cycles determined by the WLS0 and WLS1 control bits have lapsed, even though the DR signal has not been received, the PRDY signal is negated and shift register 12 is switched to again receive serial data bits via connection 16, and shift register 11 undergoes the same parallel transfer operation described above with respect to the shift register 12.

## Parallel-In/Serial-Out Mode

Refer now to Fig. 1 and the timing diagrams of Figs. 4A and 4B. In the parallel-to-serial mode, an external parallel device in the data processing system negates the POM signal thereby indicating a parallel-to-serial operation. In this mode, the circuit 10 receives parallel words over the parallel I/O port 14 and transmits serial data via connection 20 through an OR gate 22. On deassertion of a first SCI clock pulse, the circuit 10 starts the WRC clocking signal and asserts the PRDY signal when it is ready to receive a parallel word over the I/O port 14. The WRC clocking signal may be used by the parallel device to control its transfer of words to the I/O port 14. In response to the PRDY signal, the parallel device places a word on the conductors of the I/O port 14 and asserts a PLS (parallel input strobe) signal thereby to cause a transfer, in parallel, of the data bits of the word from the conductors of the I/O port 14 into the stages of an enabled non-shifting shift register, say for example, shift register 11.

Parallel data can be placed on the I/O port 14 at any time during a period determined by the status of the WLS0 and WLS1 control bits when PRDY is asserted. Once the parallel device asserts and negates the PLS signal, the PRDY signal becomes negated thereby completing the hand-shake protocol between the parallel device and the circuit 10. If the circuit 10 does not receive the PLS signal within the appropriate word-length time period, it negates the PRDY signal and asserts the O/UR signal which indicates an underrun condition. Again, depending on the status of the WLS0 and WLS1 control bits, at the end of the 8th, 10th, or 16th SCI clock cycle, shift register 12 is next conditioned to receive parallel data.

In further explanation, let us assume an operation in the sixteen-bit mode. In that case, the 16BM signal conditions the AND gates 24 and 26 so that, during a first word transfer cycle, e.g. USEL select signal asserted, an USRCK clocking signal shifts sixteen bits of information from the upper shift register 11 through the OR gate 22. Meanwhile, the circuit 10 had undergone a parallel word transfer operation using shift register 12. When all sixteen bits have been serially shifted from the register 11, the control circuit 13 negates the USEL signal and asserts the LSEL signal. On the next word transfer cycle, a LSRCK clocking signal serially shifts, bit-by-bit, the previously assembled sixteen-bit word from the shift register 12 through the OR gate 22. This process is repeated, back and forth, between shift register 11 and 12. Likewise, the 10BM and the 8BM signals enable, respectively, a pair of AND gates 28 and 30 or a pair of AND gates 32 and 34, to effect similar operations in shift registers 11 and 12, but from the 10th and 8th bit positions, instead of the 16th position thereof.

## Cascading

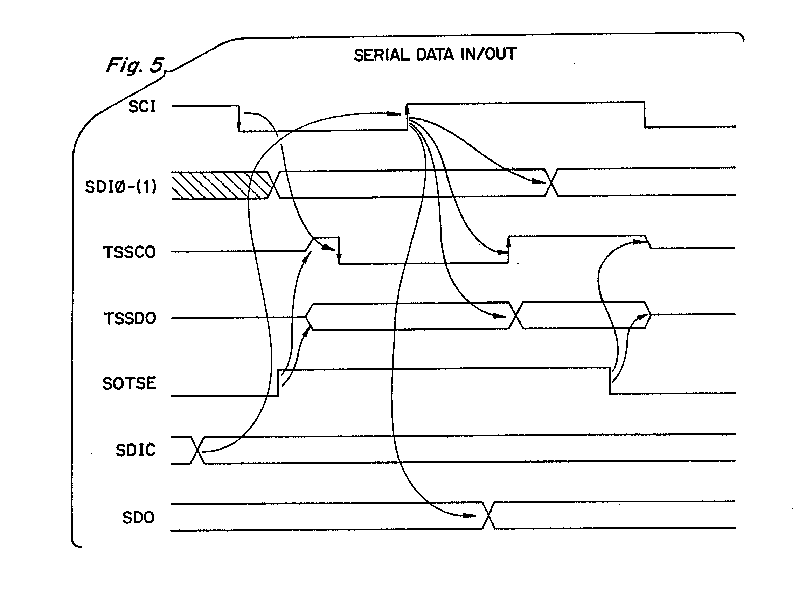

Several of the circuits 10 can be cascaded, or connected in tandem. Between parallel and serial devices, these circuits 10 connected in tandem operate, as previously explained, in either the serial-to-parallel mode or in the parallel-to-serial mode. Cascading is useful for performing other operations with the data during its passage through serveral of the circuits 10, such as, for example, generating error detecting and correcting data to be appended to the data. Fig. 5 depicts a timing diagram of the circuit while operating in the serial-to-parallel-to-serial mode.

The circuit 10 also possesses two serial output ports, the serial data output port at the SDO connection and the tri-state serial data outut port at the TSSDO connection. The SDO connection is used for cascading and it is timed with the SCI clock pulses for enabling both circuits to operate on the same clocking signals. The timing of the serial data transmitted from the TSSDO connection is closely matched with a TSSCO clocking signal that is carefully timed with the data transmitted therefrom. Such close timing might be required when the serial data on this port is to be fed to another circuit element (e.g. a flip-flop) which requires clock pulses apart from the serializer/deserializer circuit 10.

In the special case where a selected word bit-length, say 8-bit words, is less than the bit-length of the sync byte, e.g. twelve, the order of the bits in the sync pattern will be lost upon starting of parallel word transfers. This occurs because at least four bits will have shifted beyond the first eight positions of the shift register 12 at the instance when the detector circuit 18 detects the sync pattern. To avoid this situation and to preserve order in the sync pattern, we provided five or six additional stages in a shift register 36 into which the serial bits are shifted immediately after emerging from the

- 19 -

shift register 12. The next tandemly connected circuit 10, being timed with the SCI clocking pulses of a preceding circuit 10, receives the delayed bits from the shift register 36 and initiates its parallel transfer on the occurrence of a SCI clock pulse thereby to preserve the order of bits in the sync byte bit pattern. Thus, in the serial-to-parallel-to-serial 8-bit mode operation, e.g. POM asserted, there is a 21-bit delay (twenty-one SCI pulses) between the appearance of the first serial data bit at the serial input port and the emergence of the first serial bit on the SDO port at the I/O port 14. In the parallel-to-serial mode, there is only a 5-bit delay in the circuit 10 as shown.

## Description of Circuit Components

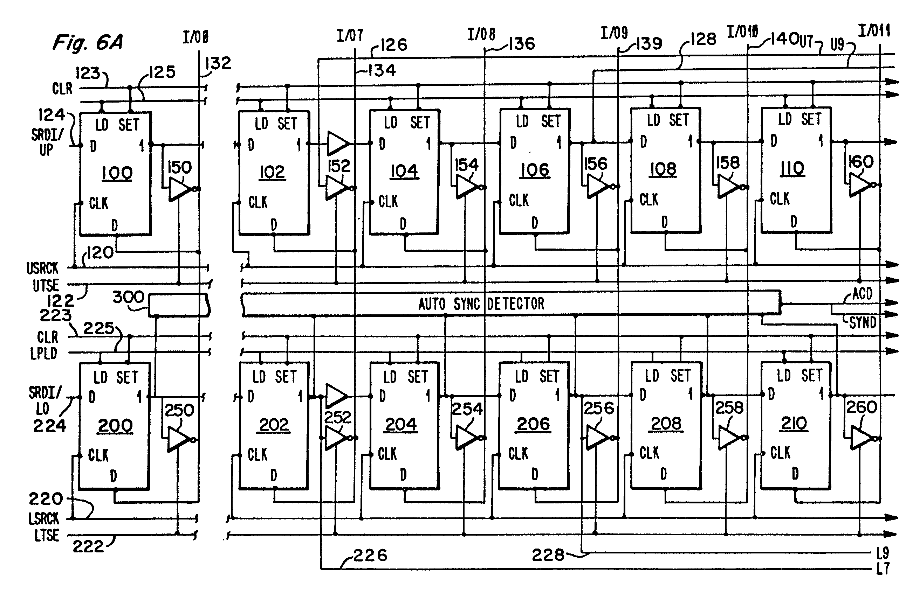

Figs. 6A and 6B show the shift register circuits 11 and 12 in greater circuit detail. As depicted therein, the register 11 consists of stages 100 through 118 and the shift register 12 consists of stages 200 through 218. A control line 120 receives the USRCK signal and supplies it to each of the stages 100 through 118 for effecting shifts of serial data bits present on serial input port 124. A control line 220 likewise controls the stages 200 through 218. Conductors 126, 128, and 130 provide serial data taps from the 8th, 10th, and 16th bit positions of the upper shift register 11. Conductors 226, 228, and 230 provide similar taps for the 8th, 10th, or 16th bit position of the lower shift register 12. As previously stated, these taps could be provided at any location of the shift registers 11 and 12 to provide other word-length conversion operations.

The parallel I/O port 14 includes a plurality of conductors 132 through 148 which couple the output of the stages of both registers 11 and 12 for transferring parallel data into the stages thereof or for transmitting parallel data therefrom. The outputs of the shift register stages are controlled, in register 11, by tri-state drivers 150 through 168, and in register 12, by tri-state drivers 250 through 268. A control conductor 122 enables, tri-state drivers 150 through 168 for transmitting parallel data from the shift register 11, and a control conductor 222 enables tri-state drivers 250 through 268 for transmitting parallel data from the register 12. The shift register circuit also includes a control conductor 125 that responds to the PLS signal by loading the stages of shift register 11 with the parallel data bits on the I/O port 14, and a control conductor 123 for clearing the contents of the shift register 11. The control conductors 225 and 223 perform similar functions with respect to shift register 12.

A "sync" pattern detector circuit 300 couples the outputs of the first twelve stages of register 12. This detector circuit might, for example, couple the stages of register 11 instead of register 12. It also might comprise a smaller or greater number of stages depending upon the particular bit pattern selected. The circuit 300 embodies

- 21 -

the previously explained threshold detector and a comparator circuit for detecting the bit pattern depicted in Fig. 2A.

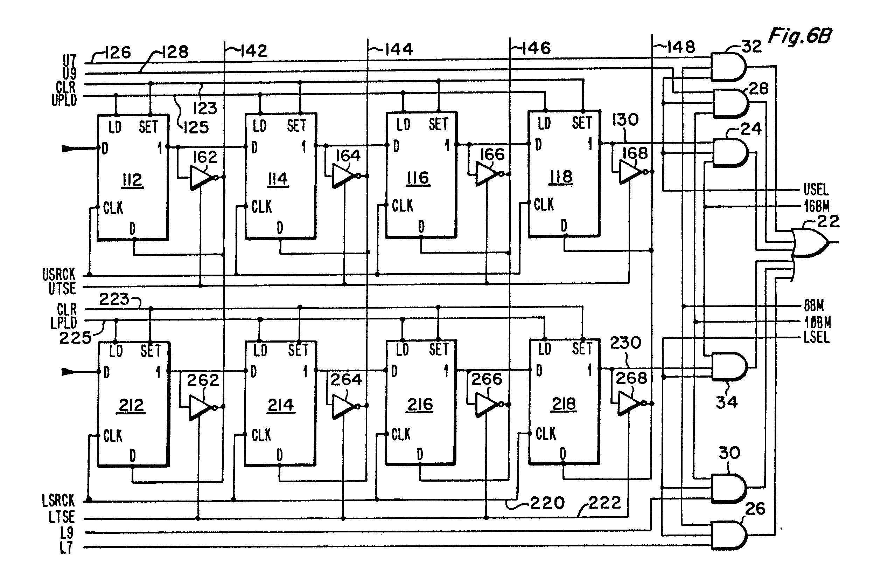

Figs. 7A and 7B depict the control circuit 13 which receives a number of control signals that determine its mode of operation and for controlling the shift register circuits shown in Figs. 6A and 6B. To facilitate a better understanding of the illustrated circuit, we describe here its salient features. The SCI clocking signal provides timing operations for all circuit elements. Control inputs for the circuit include a MR (master reset) signal, which when asserted, resets all internal registers and counters; a POM signal, which when asserted, sets the circuit 13 in the serial-to-parallel mode of operation, and when negated, sets the circuit 13 in the parallel-to-serial mode of operation. The state of WLS0 and WLS1 control bits define up to four bit-length modes of operation. In our specific embodiment, when both are asserted, the circuit 13 asserts a 16BM signal and operates in a 16-bit mode. When the WLS0 bit is asserted and the WLS1 bit is negated, the circuit 13 asserts a 10BM signal and operates in a 10-bit mode. When the WLS0 bit is negated and the WLS1 bit is asserted, the circuit 13 asserts its 8BM signal and operates in an 8-bit mode.

The circuit 13 further includes two serial input ports, represented by the SDI0 and SDI1 signals. The state of a SDIC signal determines which of these signals will carry data into the registers 11 and/or 12. These ports enable a succeeding tandemly connected circuit 10 to receive serial

- 22 -

data from both a preceding circuit 10 and another serial device.

With the POM signal asserted and after the MR master reset signal is asserted and negated, the circuit 10 will be in the search mode until it detects the unique sync pattern. In the search mode, the LSEL signal enables all serial data to feed shift register 12 which couples the detector circuit 18. After detecting the sync pattern, flip-flop 415 toggles and thereby switches the register 12 from a serial transfer operation to a parallel transfer operation. Thereafter, a CE (counter enable) signal starts a modulo-16 Johnson counter consisting of stages 400 through 414. The Johnson counter produces a sequence of control signals that enable the illustrated control logic to perform the data transfer operations in response to the SIC clocking and other input control signals. During operation of the circuit, certain status signals, such as the PRDY, WRC, O/UR signals are transmitted by the circuit 13 to facilitate data transfer operations with the parallel device connected to I/O port 14.

As previously indicated, the transfer of parallel data from the circuit 10 can occur at any time during a word time thus permitting a slower parallel word transfer that requires less power and facilitates system synchronization. In the serial-to-parallel mode, the PRDY signal emanates from an AND gate 420 when parallel data is ready to be taken from the shift register 12. Thereafter or before, the external parallel device asserts a POTSE signal which enables the tri-state drivers 200 through 218 thereby to place the contents of a selected register on the I/O port 14. After the parallel data is taken, the external parallel device transmits its DR signal to the input of AND gate 421, which, together with other control signals, serves as an acknowledgement to the receipt of the parallel data. If the DR signal is not timely received, the latch 422 generates an O/UR status signal indicating an overrun condition. The data transfer operation, however, continues. The O/UR status signal informs the data processing system of the condition so that it may, if necessary, restart the data transfer operation. When the correct number of SCI cycles has lapsed, the flip-flop 415 again toggles and the same process is repeated with the other shift register.

As previously indicated, the POM signal is negated when the circuit is to operate in the parallel-to-serial mode of operation, in which case, the circuit 13 asserts its PRDY signal from AND gate 420 when it is ready to have a parallel word loaded into a selected register 11 or 12. Upon assertion of the PRDY signal in this mode, the parallel device sends PLS pulse to the AND gate 423 after it has placed a parallel word on the I/O bus 14. When the correct number of SCI cycles has lapsed, PRDY is negated and the flip-flop 415 toggles thereby to enable the shift register which just received the parallel data to begin its serial transfer operation. If the PLS pulse has not been received after the correct number of SCI clock cycles, the O/UR status signal is asserted thereby indicating an underrun condition. The circuit 13, however, continues to function. This O/UR status signal is also sent to the data processing system so that it may, if necessary, restart the data transfer operation. Assuming that the serial device is ready to take the serial data, it will have asserted a SOTSE signal which enables an AND gate 424 to transmit serial data therefrom upon each negation of a SCI clocking pulse. When the correct number of serial data bits has been shifted from the AND gate 424, flip-flop 415 again toggles and the process is repeated with the other shift register.

The foregoing set forths a preferred embodiment of our invention. Variations thereof, embodied in the appended claims, can be constructed without departing from its teaching. Specifically, three or more shift register circuits can be used to permit an even greater time to transfer words between the parallel device and a selected shifted register. Different auto-correlation codes can also be used without departing from the scope of our invention. Accordingly, our invention is to be interpreted according to the language of those claims in light of the above teachings.

What is claimed as new and desired to be secured by Letters Patent of the United States is:

1. A circuit for serializing and deserializing digital data transferred between parallel and serial devices of a digital data processing system comprising:

    A. first shift register means including serial input and output ports and parallel input and output ports,

    B. second shift register means including serial input and output ports and parallel input and output ports, and

    C. control means for alternately selecting and enabling each of said first and second shift register means so that, in the serial-to-parallel mode of operation, one shift register means serially receives data bits while the other shift register means transmits a parallel word, and in the parallel-to-serial mode of operation, one shift register means receives a parallel word while the other shift register means transmits a parallel word as serial data bits.

2. A circuit as recited in claim 2 for serializing and deserializing digital data wherein said control means further includes:

    i. means responsive to first control signal (POM) for enabling said circuit to operate in a serial-to-parallel mode or parallel-to-serial mode,

    ii. means for generating a second control signal (PRDY) when said first control signal (POM) indicates a serial-to-parallel mode of operation for indicating that a selectable one of said shift register means is ready to transfer a parallel word, and means responsive to a third control signal (DR) that indicates that a parallel word transmitted by said selected shift register means has been received, and

iii. means for generating a fourth control signal (PRDY) when said first control signal (POM) indicates a parallel-to-serial operation for indicating that a selectable one of said shift register means is ready to receive a parallel word, and means responsive to a fifth control signal (PLS) for effecting a transfer of a parallel word to said selected shift register means.

3. A circuit as recited in claims 1 or 2 for serializing and deserializing digital data further including:

D. automatic starting and synchronizing means (18) connected to said first shift register means and being responsive to a predetermined N-bit sequence of serial data bits characterized by having auto-correlation properties such that the number of true comparisons between respective bits of said N-bit sequence and the data bits thereof that are present in the first shift register means during shifting is relatively small until all N bits of said N-bit sequence are shifted into said first shift register means thereby to generate a sixth control signal (ACD) that automatically starts and synchronizes parallel word transfer operations when the circuit operates in the serial-to-parallel mode of operation.

4. A circuit as recited in claim 3 for serializing and deserializing digital data wherein said automatic starting and synchronizing means detects a predetermined sequence of serial data bits that possess auto-correlation properties such that, during shifting, no more than K being less than N/2 will be in agreement until all N bits are present in said first shift register means.

5. A circuit as recited in claim 4 for serializing and deserializing digital data wherein said sixth control signal (ACD) is enabled by threshold means when L bits being less than N bits but greater than K bits are in agreement thereby to enable the circuit to start parallel word transfer operation when up to N-L bits of the predetermined N-bit sequence are in error.

6. A circuit as recited in claim 5 for serializing and deserializing digital data wherein N equals twelve, K equals five, L equals nine, and said predetermined N-bit sequence

equals the sequence 10011010l111 being preceded by a preamble comprised of zeroes.

7. A circuit as recited in claim 2 for serializing and deserializing digital data further including variable bit-length control means responsive to a variable bit-length control signal (WLS0,WLS1) for effecting transfers of parallel words of selectable bit-lengths.

8. A circuit as recited in claim 7 for serializing and deserializing digital data wherein said variable bit-length control means selectively enables said first and second register means to transmit and receive parallel 8-bit words, 10-bit words, or 16-bit words.

9. A circuit for serializing and deserializing digital data transferred between parallel and serial devices of a digital data processing system comprising:
   A. plural shift register means, each including serial input and output ports and parallel input and output ports,
   B. control means for periodically selecting and enabling each of said shift register means so that, in the serial-to-parallel mode of operation, one shift register means serially receives data bits while another shift register means transmits a parallel word, and in the parallel-to-serial mode of operation, one shift register means receives a parallel word while another shift·register means transmits a parallel word as serial data bits.

10. A circuit as recited in claim 9 for serializing and deserializing digital data wherein said control means further includes:

    i.    means responsive to first control signal (POM) for enabling said circuit to operate in a serial-to-parallel mode or parallel-to-serial mode,

    ii.    means for generating a second control signal (PRDY) when said first control signal (POM) indicates a serial-to-parallel mode of operation for indicating that a selectable one of said shift register means is ready to transfer a parallel word, and means responsive to a third control signal (DR) that indicates that a parallel word transmitted by said selected shift register means has been received, and

    iii.    means for generating a fourth control signal (PRDY) when said first control signal (POM) indicates a parallel-to-serial operation for indicating that a selectable one of said shift register means is ready to receive a parallel word, and means responsive to a fifth control signal (PLS) for ·effecting a transfer of a parallel word to said selected shift register means.

11. A circuit for detecting the transmission of a predetermined N-bit sequence of data bits preceded by a predetermined preamble of data bits when some of the bits of said N-bit sequence are erroneous, said predetermined N-bit sequence being characterized by having desirable auto-correlation properties such that the number of true comparisons between respective bit positions thereof when shifted is relatively small until all N bits thereof are compared, said circuit comprising:

A. receiving means for serially receiving said transmitted sequence of data bits,

B. code means for producing N code signals that correspond in an ordered sequence to the N data bits of said predetermined N-bit sequence, ordered sequence of said N code signals being the bit pattern having substantially the highest minimum distance for a pattern of length N,

C. comparing means for respectively comparing, upon receipt of each serially transmitted data bit, all received data bits with said N code signals, and

D. threshold means for generating a detect signal that indicates the transmission of said N-bit sequence even though some of the bits thereof are erroneous.

12. A circuit as recited in claim 11 wherein said N-bit sequence is further characterized in that, during shifting, no more than K being less than N/2 will be in agreement until all N bits are present in said receiving means.

13. A circuit as recited in claim 12 wherein said threshold means generates said detect signal when L or more bits are in agreement, L being less than N, but greater than K.

14. A circuit as recited in claim 13 wherein N equals twelve, K equals five, L equals nine, and said predetermined N-bit sequence of data bits equals 100110101111 being preceded by a preamble comprised of zeroes.

Fig.1

DATA FIELD    SYNC PATTERN    PREAMBLE    SHIFT REGISTER 12

X X X O O I O O I I O I O I I I I O O O O O O O O O O O →

SERIAL DATA FLOW →

[I O O I I O I O I I I I] — DETECTOR CIRCUIT 18

[O O]

*Fig. 2A*

*Fig. 2B*

NO. OF BITS IN AGREEMENT (vertical axis, 1–12)

NO. OF SYNC PATTERN BITS
IN SHIFT REGISTER 12 (horizontal axis, 0–14)

PRE-AMBLE = 000000000000000000000000

| SYNC PATTERN | MINIMUM DISTANCE | PATTERN LENGTH |
|---|---|---|
| 011 | 2 | 3 |
| 01011 | 3 | 5 |
| 10111 | 3 | 5 |
| 0010111 | 4 | 7 |
| 0011101 | 4 | 7 |
| 0100111 | 4 | 7 |
| 0110111 | 4 | 7 |
| 010010111 | 5 | 9 |
| 010110111 | 5 | 9 |
| 011010111 | 5 | 9 |
| 100101111 | 5 | 9 |
| 100111101 | 5 | 9 |
| 101001111 | 5 | 9 |
| 101100111 | 5 | 9 |
| 00010110111 | 6 | 11 |
| 00011010111 | 6 | 11 |
| 00011101101 | 6 | 11 |
| 00101001111 | 6 | 11 |
| 00110101111 | 6 | 11 |
| 01100101111 | 6 | 11 |
| 01100111101 | 6 | 11 |
| 01101100111 | 6 | 11 |
| 10100110111 | 6 | 11 |
| 10100111011 | 6 | 11 |
| 11011010111 | 6 | 11 |
| 100110101111 | 7 | 12 |

*Fig. 2C*

PRE-AMBLE = 001001001001001001001001

| SYNC PATTERN | MINIMUM DISTANCE | PATTERN LENGTH |
|---|---|---|
| 0111 | 2 | 4 |
| 101111 | 3 | 6 |
| 110001 | 3 | 6 |
| 10011101 | 4 | 8 |
| 0110011101 | 5 | 10 |

*Fig. 2E*

PRE-AMBLE = 01010101010101010101010101

| SYNC PATTERN | MINIMUM DISTANCE | PATTERN LENGTH |
|---|---|---|
| 0011 | 2 | 4 |
| 1001 | 2 | 4 |
| 111001 | 3 | 6 |
| 000111001 | 4 | 9 |
| 001001111 | 4 | 9 |
| 001101001 | 4 | 9 |
| 001101101 | 4 | 9 |
| 001101111 | 4 | 9 |
| 010000111 | 4 | 9 |
| 010011100 | 4 | 9 |
| 010011111 | 4 | 9 |
| 010110001 | 4 | 9 |
| 010110100 | 4 | 9 |
| 010110111 | 4 | 9 |
| 011001111 | 4 | 9 |
| 011100001 | 4 | 9 |
| 011111001 | 4 | 9 |
| 100011011 | 4 | 9 |
| 100100001 | 4 | 9 |
| 100100111 | 4 | 9 |
| 100101101 | 4 | 9 |
| 110001001 | 4 | 9 |
| 110001101 | 4 | 9 |
| 111001001 | 4 | 9 |
| 00001101001 | 5 | 11 |
| 00001101101 | 5 | 11 |
| 00010110111 | 5 | 11 |
| 00011001001 | 5 | 11 |
| 00011101101 | 5 | 11 |
| 00111101001 | 5 | 11 |
| 00111101101 | 5 | 11 |
| 01011011100 | 5 | 11 |
| 01110110100 | 5 | 11 |
| 01111001001 | 5 | 11 |
| 10000100111 | 5 | 11 |
| 10000110011 | 5 | 11 |
| 10010000111 | 5 | 11 |
| 10011100001 | 5 | 11 |
| 10110011000 | 5 | 11 |
| 10110100111 | 5 | 11 |
| 10110111100 | 5 | 11 |
| 11000001001 | 5 | 11 |
| 11000001101 | 5 | 11 |
| 11000010011 | 5 | 11 |
| 11001000011 | 5 | 11 |
| 11001101001 | 5 | 11 |
| 11010000100 | 5 | 11 |
| 11010110001 | 5 | 11 |
| 11010110100 | 5 | 11 |
| 11011000001 | 5 | 11 |
| 11011100001 | 5 | 11 |
| 11100001001 | 5 | 11 |
| 11100011011 | 5 | 11 |
| 11100100001 | 5 | 11 |
| 11100101101 | 5 | 11 |
| 11110001001 | 5 | 11 |
| 11110001101 | 5 | 11 |

Fig. 2D

**SERIAL-IN/PARALLEL OUT MODE**

*Fig. 3A*

Fig. 3B

POTSE

DR

PRDY

PARALLEL-IN/
SERIAL-OUT MODE

Fig. 4A

SCI    0 1 2 3   4,5,8   13 14 15   0 1 2

PRDY

PLS

O/UR

WRC

Fig. 4B

PLS

I/O<0-15>    VALID INPUT DATA

Fig. 5

SERIAL DATA IN/OUT

SCI

SDI0-(1)

TSSCO

TSSDO

SOTSE

SDIC

SDO

Fig. 6A

Fig.6B

0067384